# EUROPÄISCHE PATENTSCHRIFT

(11) **EP 2 209 683 B1**
(45) Veröffentlichungstag und Bekanntmachung des Hinweises auf die Patenterteilung: **06.07.2011**
(21) Anmeldenummer: 08735942.8
(22) Anmeldetag: 08.04.2008
(51) Int. Cl.: B60T 17/22, B60T 11/22, G01F 23/72, H01H 36/02, G01R 27/20, G01R 31/327

(54) **VERFAHREN ZUR PRÜFUNG EINER BEHÄLTERWARNVORRICHTUNG EINES AUSGLEICHSBEHÄLTERS SOWIE PRÜFVORRICHTUNG ZUR PRÜFUNG EINER BEHÄLTERWARNVORRICHTUNG**
METHOD FOR TESTING A CONTAINER WARNING DEVICE OF A COMPENSATION CONTAINER, AND TESTING APPARATUS FOR TESTING A CONTAINER WARNING DEVICE
PROCÉDÉ ET DISPOSITIF DE VÉRIFICATION D'UN DISPOSITIF DE SURVEILLANCE DE RÉSERVOIR D'UN RÉSERVOIR DE COMPENSATION

(30) Priorität: 22.06.2007 DE 102007029331; 24.08.2007 DE 102007040044
(43) Veröffentlichungstag der Anmeldung: 28.07.2010
(73) Patentinhaber: Continental Teves AG & Co. OHG, 60488 Frankfurt (DE)
(72) Erfinder: NEUMANN, Hans-Jürgen, 65428 Rüsselsheim (DE); LUDWIG, Johann, 61449 Steinbach (DE); TANDLER, Peter, 61476 Kronberg (DE)
(86) Internationale Anmeldenummer: PCT/EP2008/054214
(87) Internationale Veröffentlichungsnummer: WO 2009/000569

(56) Entgegenhaltungen:
- DE-A1-102005 009 657
- US-A- 4 028 615

## Beschreibung

Die Erfindung betrifft ein Verfahren zur Prüfung einer Behälterwarnvorrichtung eines Ausgleichsbehälters, insbesondere für eine hydraulische Kraftfahrzeugbremsanlage, wobei die Behälterwarnvorrichtung eine Schalteinheit mit wenigstens einem Reed-Kontakt als Schaltelement umfasst, sowie eine Prüfvorrichtung zum Prüfen einer Behälterwarnvorrichtung.

In einer hydraulischen Kraftfahrzeugbremsanlage befindet sich die benötigte Bremsflüssigkeit in dem Ausgleichsbehälter, wobei die Behälterwarnvorrichtung zum Überwachen des Behälterfüllstandes als Schaltelement üblicherweise einen Reed-Schalter mit einem Reed-Kontakt und als Geber üblicherweise einen Magneten aufweist.

Bekanntermaßen besteht ein Reed-Kontakt aus zwei edelmetallbeschichteten ferromagnetischen Schaltzungen, die hermetisch dicht verschlossen in ein Glaskörper bzw. Glasröhrchen eingeschmolzen werden. Die beiden Schaltzungen überlappen sich dabei minimal. Das Glasröhrchen wird vor dem Einschmelzen evakuiert und zum Teil mit Stickstoff oder einer Gasmischung mit hohem Stickstoffanteil gefüllt.

Senkt sich der Bremsflüssigkeitsstand und passiert der Magnet einen vorgegebenen Schaltpunkt, so schließen sich Schaltzungen des Reed-Schalters durch das erzeugte Magnetfeld, indem die magnetische Anziehungskraft der Schaltzungen die Federwirkung der einzelnen Schaltzungen übersteigt. Der Reed-Schalter kann, wie beschrieben, als Schließer bzw. NO-Schalter vorgesehen sein, bei welchem die Schaltzungen in Ruhestellung geöffnet sind. Jedoch ist auch der Einsatz eines als Öffner bzw. NC-Schalter ausgebildeten Reed-Schalters möglich, welcher im Ruhezustand geschlossene Schaltzungen aufweist, die unter Einwirkung einer Magnetkraft geöffnet werden.

Dieses Signal wird in einem Steuergerät ausgewertet und der Fahrer des Kraftfahrzeuges kann durch eine optische und/oder akustische Anzeige gewarnt werden. Dabei muss sichergestellt sein, dass der Ausgleichsbehälter immer mit einem gesetzlich festgelegten Minimum an Bremsflüssigkeit gefüllt ist, um die Funktion der Bremsanlage nicht in Frage zu stellen. In der Regel werden Behälterwarnvorrichtungen zum Überwachen des Behälterfüllstandes verwendet, bei denen ein mit dem Magneten versehener Schwimmer den Reed-Kontakt schaltet, sobald der Schwimmer eine Lage (Schaltpunkt) einnimmt, in der der Behälterfüllstand ein definiertes Minimum unterschreitet. Durch den Reed-Kontakt wird ein für den Fahrer erkennbares Warnsignal ausgelöst.

Ein Ausgleichsbehälter für eine hydraulische Kraftfahrzeugbremsanlage sowie eine beschriebene Schalteinheit sind beispielsweise aus der DE 10 2005 009 657 A1 bekannt.

Aus der US 4,028,615 A ist ein Verfahren und eine Anordnung zum Prüfen hermetisch eingeschlossener Zungenkontakten auf elektrisch mangelhaft leitendes Material bekannt. Um auf elektrisch nicht oder mangelhaft leitendes Material auf der Kontaktstelle schließen zu können, wird hierzu ein Wechselstrom mit einer zwischen einem Höchst- und Mindestwert pendelnden Frequenz an den Reedkontakt angelegt, wobei der ermittelte Kontaktwiderstand Rückschlüsse auf die Qualität des elektrisch leitenden Materials zulässt. Ferner wird das Berechnen einer Biegeresonanzfrequenz beschrieben.

Die Behälterwarnvorrichtungen werden gemäß der heutigen Praxis einer Schaltpunktprüfung sowie einer Schwenkprüfung (180° Drehung) im eingebauten Zustand unterzogen, d.h. nach Einbau der Behälterwarnvorrichtung in den Ausgleichsbehälter.

Trotz dieser Prüfungen kommt es häufig zu Ausfällen bei den Schalteinheiten mit Reedkontakten, da durch die Schaltpunkt- und Schwenkprüfung einige Herstellungsfehler nicht aufgefunden werden und durch das Handling (Transport, Montage etc.) spätere Fehler im Feld auftreten können.

Mögliche Fehler bzw. Ausfälle die an einem eingebauten Reed - Kontakt im Feld auftreten können, sind:
- Gebrochene Glaskörper (Haarrisse)
- Undichtheiten zwischen Glaskörper und Kontakten
- Schwebende Partikel im Glaskörper
- Verbogene Schaltzungen im Glaskörper
- Schiefe Ausrichtung der Schaltzungen im Glaskörper
- Neigung zum Kleben der Schaltzungen im Kontaktbereich

Es ist daher Aufgabe der Erfindung, ein Prüfverfahren und eine Prüfvorrichtung bereitzustellen, mit welchem alle möglichen Fehler des Reed-Kontaktes auffindbar sind.

Die Aufgabe wird durch das erfindungsgemäße Verfahren zur Prüfung einer Behälterwarnvorrichtung gelöst, welches vorsieht, dass an der vormontierten Schalteinheit ein dynamischer Übergangswiderstand sowie ein Einschwingverhalten des Reed-Kontaktes gemessen werden. Durch diese Prüfung können alle möglichen Fehler an der vormontierten Schalteinheit aufgezeigt werden, da mögliche negative Einflüsse durch Handling und Montage bereits auf den Reed-Kontakt stattgefunden haben.

Gemäß einer vorteilhaften Ausführung des erfindungsgemäßen Verfahrens wird an der vormontierten Schalteinheit eine Empfindlichkeit einer Anzugserregung sowie einer Abfallerregung des Reed-Kontaktes gemessen. Hierdurch kann festgestellt werden, ob die vorab für die Funktion festgelegte Empfindlichkeit des Reed-Kontaktes eingehalten werden kann.

Vorzugsweise wird an der vormontierten Schalteinheit ein statischer Übergangswiderstand des Reed-Kontaktes gemessen. Auch dieser Wert ist vorab für Funktion festgelegt und kann mit diesem Verfahrensschritt überprüft werden.

Als weiterer vorteilhafter Verfahrensschritt kann an der vormontierten Schalteinheit ein Schaltweg sowie eine Schaltzeit gemessen werden.

Vorzugsweise sind die Prüfschritte in den Fertigungsprozess der Schalteinheit integriert. Hierdurch kann ein zusätzliches Handling der Schalteinheiten vermieden werden.

Gemäß einer vorteilhaften Weiterbildung des erfindungsgemäßen Verfahrens werden wenigstens zwei Messungen des statischen Übergangswiderstandes durchgeführt und eine Widerstands-Differenz wird ermittelt.

Dabei werden vorzugsweise zehn Messungen des statischen Übergangswiderstandes durchgeführt und eine max. Widerstands-Differenz wird ermittelt.

Eine weitere vorteilhafte Weiterbildung sieht vor, dass wenigstens zwei Messungen des dynamischen Übergangswiderstandes durchgeführt werden und eine Widerstands-Differenz ermittelt wird.

Es ist besonders vorteilhaft, wenn hundert Messungen des dynamischen Übergangswiderstandes durchgeführt werden und eine max. Widerstands-Differenz ermittelt wird.

Um die Messungen zu dokumentieren, wird die Schalteinheit vorzugsweise mit den Prüfwerten gekennzeichnet.

Als besonders vorteilhafte Kennzeichnung bietet es sich gemäß einer vorteilhaften Ausführung an, dass die einzelnen Prüfwerte als Data Matrix Code verschlüsselt auf die Schalteinheit aufgetragen werden. Somit können die Prüfwerte sehr kompakt codiert werden.

Hierbei wird die Kennzeichnung besonders einfach und sicher aufgebracht, indem der Data Matrix Code auf die Schalteinheit aufgelasert wird.

Weiter wird Aufgabe durch eine Prüfvorrichtung zur Prüfung einer Behälterwarnvorrichtung umfassend eine Schalteinheit mit wenigstens einem Reed-Kontakt als Schaltelement gelöst, mittels welcher die Prüfung der Schalteinheit mittels eines erfindungsgemäßen Verfahrens zur Prüfung ausführbar ist.

Vorzugsweise ist die Prüfvorrichtung in eine Fertigungseinheit integriert vorgesehen.

Weitere Merkmale, Vorteile und Anwendungsmöglichkeiten der Erfindung gehen aus der nachfolgenden Beschreibung eines Ausführungsbeispiels hervor. Es zeigt jeweils stark schematisiert sowie teilweise im Schnitt:
- Figur 1: eine Schalteinheit einer Behälterwarnvorrichtung eines Ausgleichsbehälters im Längsschnitt;
- Figur 2: einen entsprechenden Ausgleichsbehälter einer hydraulischen Kraftfahrzeugbremsanlage in räumlicher Draufsicht und
- Figur 3: eine zweite Ausführungsform einer Schalteinheit einer Behälterwarnvorrichtung eines Ausgleichsbehälters im Längsschnitt.

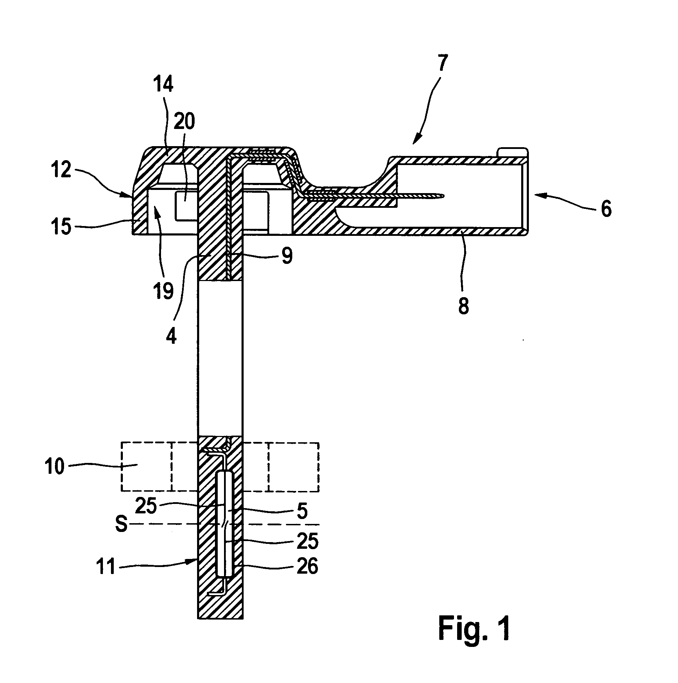

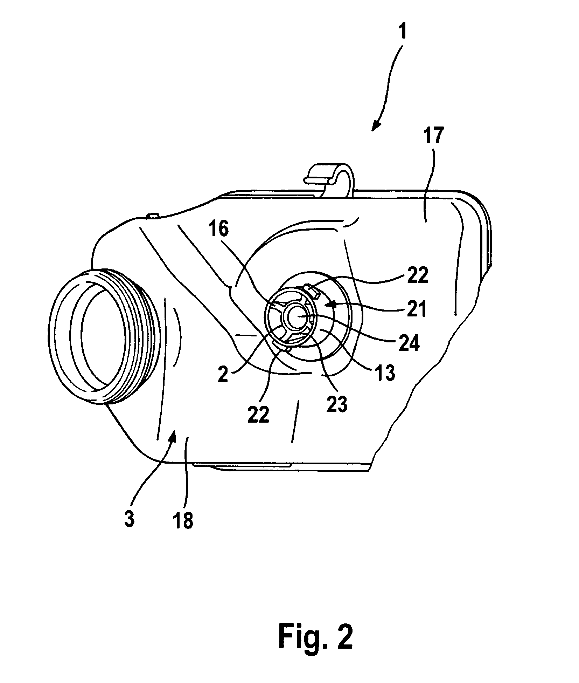

Fig. 1 und 2 zeigen eine Schalteinheit 7 einer Behälterwarnvorrichtung eines Ausgleichsbehälters 1 im Längsschnitt sowie den entsprechenden Ausgleichsbehälter 1 in räumlicher Draufsicht, der beispielsweise an einem nicht dargestellten Hauptzylinder einer hydraulischen Kraftfahrzeugbremsanlage befestigt ist. Das beschriebene Verfahren zur Prüfung ist an der beispielhaft dargestellten Schalteinheit 7 mittels der beschriebenen Prüfvorrichtung anwendbar.

Ausgleichsbehälter und deren Komponenten für hydraulische Kraftfahrzeugbremsanlagen sind allgemein bekannt. Das erfindungsgemäße Verfahren und die erfindungsgemäße Prüfvorrichtung sind grundsätzlich auf alle Behälterwarnvorrichtungen anwendbar, welche eine Schalteinheit mit Reed-Kontakt aufweisen.

Der Ausgleichsbehälter 1 besteht aus einem Gehäuse 3 umfassend ein Gehäuseunterteil und ein Gehäuseoberteil, welche an ihren Rändern und an Zwischenwänden miteinander verschweißt sind, und weist ein in sein Inneres ragendes Führungsrohr 2 auf, das an seinem, dem Behälterinneren zugewandten Ende verschlossen ist.

Längs des Führungsrohres 2, das beispielsweise einen kreisförmigen Querschnitt hat, ist ein schematisch angedeuteter Schwimmer 10 verschiebbar angeordnet, der z.B. als Ring ausgebildet ist und einen Bestandteil einer Behälterwarnvorrichtung zum Überwachen des Behälterfüllstandes darstellt. Der Schwimmer 10 trägt einen ringförmigen Magneten als magnetischen Geber. Ein vom Boden des Ausgleichsbehälters 1 emporragender, erster Anschlag begrenzt die Verschiebung des Schwimmers auf dem Führungsrohr 2 in Richtung Boden. Dieser Anschlag legt die tiefste Stellung des Schwimmers 10 im Ausgleichsbehälter 1 fest und verhindert, dass der Schwimmer das Führungsrohr 2 verlassen kann.

Der Schwimmer 10 kann einstückig vorgesehen sein und eine radiale Aussparung aufweisen, in welche der ringförmige Magnet geschoben wird. Seitenwände der Aussparung sind dabei mit Haltemitteln versehen, welche den Magneten in seiner Einbaulage sichern. Der Magnet kann als kunststoffgebundener Dauermagnet vorgesehen sein, wodurch der Magnet bruchfest ist und Absplitterungen des Magneten, die im schlimmsten Fall zu einem Verkeilen des Schwimmers 10 auf dem Führungsrohr 2 führen, vermieden werden können.

Die Behälterwarnvorrichtung zum Überwachen des Behälterfüllstandes umfasst die Schalteinheit 7 mit einem Kontaktträger 4, welcher im Inneren des Führungsrohrs 2 vorgesehen ist und an dem ein Reed-Schalter mit einem Reed-Kontakt 5 als Schaltelement befestigt ist. Die Schalteinheit 7 kann auch mehrere Reed-Kontakte 5 aufweisen.
Weiter umfasst die Schalteinheit 7 einen Steckverbinder 6 mit einem Gehäuse 8 und kann, um die Montage zu erleichtern und die Herstellung der Schalteinheit 7 zu vereinfachen, wie dargestellt, einteilig aus einem Kunststoffwerkstoff ausgebildet sein. Kontaktfahnen 9, an welchen der Reed-Schalter 5 befestigt ist, sowie andere Bauteile, wie beispielsweise Widerstände, sind in den Kontaktträger 4 beispielsweise eingespritzt vorgesehen.

Sobald der Magnet durch Absinken des Behälterfüllstandes einen Schaltpunkt S des Reed-Kontaktes 5 passiert, schließen sich Schaltzungen des Reed-Kontaktes 5 durch das erzeugte Magnetfeld des Magneten, indem die magnetische Anziehungskraft der Schaltzungen die Federwirkung der einzelnen Schaltzungen übersteigt. Der Reed-Kontakt 5 kann als Schließer bzw. NO-Schalter vorgesehen sein, bei welchem die Schaltzungen in Ruhestellung geöffnet sind. Jedoch ist auch der Einsatz eines als Öffner bzw. NC-Schalter ausgebildeten Reed-Kontaktes 5 möglich, welcher im Ruhezustand geschlossene Schaltzungen aufweist, die unter Einwirkung einer Magnetkraft geöffnet werden. Durch den Schaltvorgang wird ein Signal für eine elektronische Schalteinheit der Kraftfahrzeugbremsanlage generiert.

Andere Ausführungsformen des Ausgleichsbehälters 1 sehen vor, dass sich die Schalteinheit von einer Seitenwand in die Druckkammern erstreckt, wobei der magnetische Geber über der Schalteinheit angeordnet ist. Auch eine Anordnung der Schalteinheit am Boden des Ausgleichsbehälters ist denkbar.

Fig. 1 zeigt die Anordnung des Reed-Schalters 5 nur schematisch. So ist es denkbar, den Reed-Kontakt 5 in einer Ausnehmung des Kontaktträgers 4 anzuordnen und darin mit den Kontaktfahnen 9 zu befestigen. Um den Reed-Kontakt 5 zu schützen, kann dieser, wie in Fig. 1 angedeutet, in das Material des Kontaktträgers 4 eingebetet sein. Hierzu kann der Kontaktträger4 beispielsweise im Bereich des Reed-Kontaktes 5 mit dem gleichen Material umspritzt werden bzw. kann ein Abschnitt 11 des Kontaktträgers 4, der in ein Führungsrohr 2 des Ausgleichsbehälters 1 hineinragt, nach Befestigung des Reed-Kontaktes 5 umhüllt werden.

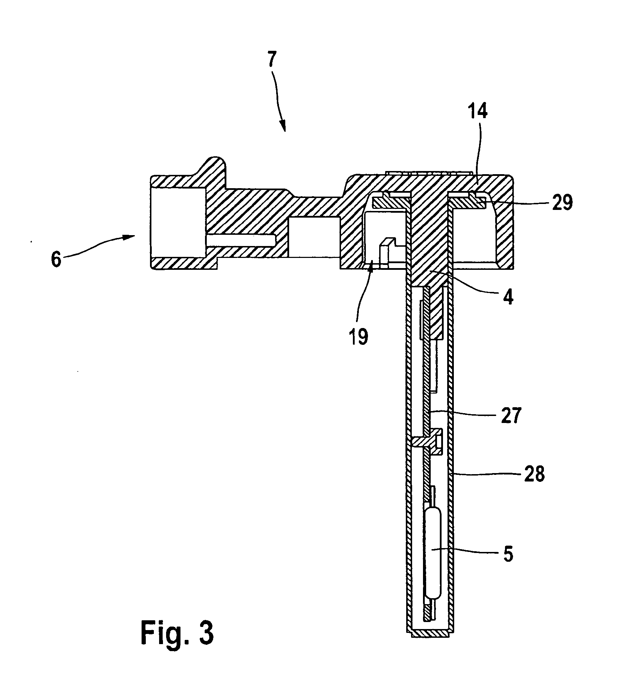

Alternativ kann der Reed-Kontakt 5 an einer Leiterplatte 27 befestigt sein, welche an dem Kontaktträger 4 befestigt vorgesehen ist, wie Fig. 3 zu entnehmen ist. Die Leiterplatte 27 sowie ein Teil des Kontaktträgers 4 sind zum Schutz von einer rohrförmigen Hülle 28 umgeben, welche mit einem Flansch 29 an dem Kontaktträger 4 angeschweißt und in Richtung Behälterinnenraum geschlossen vorgesehen ist. Die Hülle 28 ragt bei dieser Ausführungsform der Schalteinheit 7 in das Führungsrohr 2 hinein.

Um eine lösbare Verbindung der Schalteinheit 7 mit dem Gehäuse 3 des Ausgleichsbehälters 1 zu ermöglichen, kann der Kontaktträger 4 einen topfförmigen Abschnitt 12 aufweisen, welcher mit einem am Gehäuse 3 ausgebildeten ringförmigen Vorsprung 13 zusammenwirkt. Der den Reed-Kontakt 5 tragende Abschnitt 11 des Kontaktträgers 4 erstreckt sich mittig von einem Boden 14 des topfförmigen Abschnittes 12 und das Gehäuse 8 des Steckverbinders 6 ist senkrecht in Bezug auf eine Längsachse der Schalteinheit 7 an eine Wandung 15 des topfförmigen Abschnittes 12 angeformt.

Ist der Reed-Kontakt 5 gemäß Fig. 3 auf der Leiterplatte 27 angeordnet, ist der Flansch 29 der Hülle 28 an einer Innenseite 19 des topfförmigen Abschnittes 12 im Bereich eines Bodens 14 angeschweißt.

Wie weiter ersichtlich ist, ist das Führungsrohr 2 konzentrisch innerhalb des ringförmigen Vorsprungs 13 vorgesehen, wobei zur Verstärkung des Ausgleichsbehälters 1 im Bereich des ringförmigen Vorsprunges 13 zwischen dem ringförmigen Vorsprung 13 und dem Führungsrohr 2 Verstärkungsrippen 16 vorgesehen sind, welche in Fig. 1 dargestellt sind.

Um das Packaging des Ausgleichsbehälters 1 zu optimieren, ist der ringförmige Vorsprung 13 in einem Bereich 17 des Gehäuses 3 angeordnet, welcher im Vergleich zum restlichen Bereich 18 des Gehäuses 3 in Richtung Behälterinnenraum versetzt vorgesehen ist. Somit steht die Schalteinheit 7 nicht über das Gehäuse 3 hervor und kann weder beim Transport noch im eingebauten Zustand des Ausgleichsbehälters 1 hinderlich sein. Ferner kann durch die gezeigte Gehäusegeometrie vermieden werden, dass die Schalteinheit 7 in einer falschen Lage - beispielsweise um 180° in Bezug auf deren Längsachse verdreht - eingebaut wird.

Eine lösbare Verbindung des Kontaktträgers 4 mit dem umlaufenden Vorsprung 13 kann beispielsweise als Bajonettverbindung ausgestaltet, welche auf der Innenseite 19 des topfförmigen Abschnittes 12 zwei diametral gegenüberliegende Ausbrüche 20 mit Hinterscheidungen und auf einer Außenseite 21 des ringförmigen Vorsprunges 13 zwei diametral gegenüberliegende Rippen 22 umfasst. Diese Verbindung erlaubt eine einfache Austauschbarkeit der Schalteinheit 7 ohne die Verwendung eines Werkzeuges, wobei die Hinterscheidungen ein ungewolltes Lösen der Verbindung verhindern. Hierbei ist es möglich, auch andere rastende Verbindungen vorzusehen, wie beispielsweise eine SchnappVerbindung mit federnden Schnapp-Elementen und entsprechenden Elementen zum Einschnappen der Schnapp-Elemente.

Der ringförmige Vorsprung 13 ist federnd ausgebildet und dessen Rand 23 liegt dichtend an der Innenseite 19 des topfförmigen Abschnittes 12 an. Hierdurch kommt dem ringförmigen Vorsprung 13 eine Doppelfunktion zu, da der Vorsprung 13 einerseits einen Innenraum 24 des Führungsrohres 2 gegen ein Eindringen von Spritzwasser schützt und andererseits die Ausbrüche 20 gegen die Rippen 22 der Bajonettverbindung drückt. Durch die Ausgestaltung der Rippen 22 und der Ausbrüche 20 ist die Eindrehrichtung der Schalteinheit 7 festgelegt und erfolgt entweder gegen den Uhrzeigersinn oder mit dem Uhrzeigersinn bis zum Einrasten der Bajonettverbindung. Die Demontage der Schalteinheit 7 erfolgt durch Eindrücken der Schalteinheit 7 gegen den Rand 23 des ringförmigen Vorsprunges 13 und Drehen gegen oder im Uhrzeigersinn bis sich die Bajonettverbindung löst.

Um eine funktionssichere und robuste Schalteinheit 7 der Behälterwarnvorrichtung bei gleichzeitiger Kostenreduzierung zu erhalten, können der Reed-Kontakt 5 und der Magnet derart schaltoptimiert aufeinander abgestimmt werden, dass der Magnet an einer einzigen Schaltkeule des Reed-Kontaktes 5 schaltet, indem die magnetische Flussdichte des Magnetes und die Schaltempfindlichkeit der Schalteinheit 7 aufeinander abgestimmt werden. Dadurch ist nur eine so genannte Hauptkeule des Reed-Kontaktes 5 wirksam und das definierte Schaltverhalten am vorgegebenen Schaltpunkt S ist sichergestellt, wodurch eine exakte Positionierung der Anschläge entfallen kann bzw. wodurch die Anschläge vollkommen entfallen können.

Der Reed-Kontakt 5, welcher in Fig. 1 schematisch dargestellt ist, besteht aus zwei edelmetallbeschichteten ferromagnetischen Schaltzungen 25, die hermetisch dicht verschlossen in ein Glaskörper bzw. Glasröhrchen 26 eingeschmolzen werden. Die beiden Schaltzungen 25 überlappen sich dabei minimal. Das Glasröhrchen 26 wird vor dem Einschmelzen evakuiert und zum Teil mit Stickstoff oder einer Gasmischung mit hohem Stickstoffanteil gefüllt.

Das erfindungsgemäße Verfahren zur Prüfung der Behälterwarnvorrichtung sieht vor, dass an der, wie in Fig. 1 dargestellten, vormontierten Schalteinheit 7 ein dynamischer Übergangswiderstand sowie ein Einschwingverhalten des Reed-Kontaktes gemessen werden. Durch diese Prüfung können alle möglichen Fehler an der vormontierten Schalteinheit 7 aufgezeigt werden, da mögliche negative Einflüsse durch Handling und Montage bereits auf den Reed-Kontakt 5 stattgefunden haben. Mögliche Fehler sind: Gebrochenes Glasröhrchen 26 (Haarrisse), Undichtheiten zwischen Glasröhrchen und Schaltzungen 25, schwebende Partikel im Glasröhrchen 26, verbogene Schaltzungen 25 im Glasröhrchen 26, schiefe Ausrichtung der Schaltzungen 25 im Glasröhrchen 26, Neigung zum Kleben der Schaltzungen 25 im Kontaktbereich, etc..

Zum Messen des dynamischen Übergangswiderstandes, der auch dynamischer Kontaktwiderstand genannt wird, wird der Reed-Kontakt 5 der Schalteinheit 7 mit einer bestimmten Frequenz von beispielsweise 100 Hz geschaltet, wobei das Messergebnis mittels eines Oszillographen angezeigt werden kann. Ebenso kann das Messergebnis digitalisiert werden.
Durch ein Takten des Reed-Kontaktes 5 mit der bestimmten Frequenz folgt ein periodisches Öffnen und Schließen des Reed-Kontaktes 5 für eine bestimmte Zeitspanne von ca. 0,5 ms. Der Reed-Kontakt 5 prellt ca. 0,1 ms, danach folgt das so genannte dynamische Rauschen für ca. 0,5 ms, währenddessen der Reed-Kontakt 5 noch nicht geschlossen ist und schwingt ohne zu Öffnen. Hierbei schwankt der Übergangswiderstand noch in großen Grenzen und verbessert sich kontinuierlich während der ersten 0,5 ms. Wenn das dynamische Rauschen abgeklungen ist, setzt die letzte Einschwingphase ein. Dabei ist der Kontakt zwar geschlossen, jedoch dauert es noch immer ca. 1 ms bis zur endgültigen geschlossenen Position mit festem Übergangswiderstand. Das heißt ca. 1,5 ms nach Anlage der Messspulenspannung hat der Reed-Kontakt 5 seine Arbeitsposition erreicht. So erlaubt das Einschwingverhalten Rückschlüsse auf die Qualität des Reed-Kontaktes 5: Falls sich eine erhöhte Prellzeit von mehr als 0,25 ms zeigt, ist mit einem erhöhten Ausfallrisiko des Reed-Kontaktes 5 speziell bei lastfreiem Schalten zu rechnen.

Falls sich Rauschen oder das Einschwingen über den spezifischen Zeitraum von 1,5 ms erhöht bzw. falls die Einschwingkurve erhöhte Amplitudenwerte zeigt, lassen sich Rückschlüsse auf eine fehlerhafte Einschmelzzone bzw. auf ein gebrochenes Glasröhrchen 26 ziehen.

Dieser Prüfschritt wird in beispielsweise ca. 100 Messungen wiederholt, um eine maximale Widerstands-Differenz des dynamischen Übergangswiderstandes zu ermitteln. Hieraus können Rückschlüsse auf eine interne Verschmutzung des Reed-Kontaktes 5, auf mechanische Verspannungen oder auch fehlerhafte Schaltzungenoberflächen gezogen werden, falls sich der Übergangswiderstand bei den Messungen verändert.

Um festzustellen, ob die vorab für die Funktion festgelegte Empfindlichkeit des Reed-Kontaktes 5 eingehalten wird, wird vor der Messung des dynamischen Übergangswiderstandes die Empfindlichkeit einer Anzugserregung sowie einer Abfallerregung des Reed-Kontaktes 5 mittels einer speziellen Messspule gemessen.

Als weiteren Prüfschritt kann sich hieran eine Messung des statischen Übergangswiderstands des Reed-Kontaktes 5 anschließen. Auch dieser Wert ist vorab für Funktion festgelegt und kann mit diesem Verfahrensschritt überprüft werden.

Zur Ermittlung einer maximalen Widerstands-Differenz des statischen Übergangswiderstandes werden ca. 10 Messungen durchgeführt.

Nach der Messung des dynamischen Überganswiderstands folgt als nächster Verfahrensschrift eine Messung des Schaltweges sowie der Schaltzeit der vormontierten Schalteinheit 7 mit einem Magneten, wie er im Ausgleichsbehälter eingesetzt wird.

Zur Dokumentation werden die Schalteinheiten 7 mit den Prüfwerten gekennzeichnet. Hierzu werden die einzelnen Prüfwerte beispielsweise als Data Matrix Code verschlüsselt auf die Schalteinheit 7 aufgelasert.

Die vorstehend beschriebenen Prüfschritte werden mittels einer Prüfvorrichtung durchgeführt, welche in den Fertigungsprozess der Schalteinheit 7 integriert ist, wodurch ein zusätzliches Handling der Schalteinheiten 7 vermieden werden kann.

### Bezugszeichenliste

- 1: Ausgleichsbehälter
- 2: Führungsrohr
- 3: Gehäuse
- 4: Kontaktträger
- 5: Reed-Kontakt
- 6: Steckverbinder
- 7: Schalteinheit
- 8: Gehäuse
- 9: Kontaktfahne
- 10: Schwimmer
- 11: Abschnitt
- 12: Abschnitt
- 13: Vorsprung
- 14: Boden
- 15: Wandung
- 16: Rippe
- 17: Bereich
- 18: Bereich
- 19: Innenseite
- 20: Ausbruch
- 21: Außenseite
- 22: Rippe
- 23: Rand
- 24: Innenraum
- 25: Schaltzunge
- 26: Glasröhrchen
- 27: Leiterplatte
- 28: Hülle
- 29: Flansch

- S: Schaltpunkt

## Patentansprüche

1. Verfahren zur Prüfung einer Behälterwarnvorrichtung eines Ausgleichsbehälters (1), insbesondere für eine hydraulische Kraftfahrzeugbremsanlage, wobei die Behälterwarnvorrichtung eine Schalteinheit (7) mit wenigstens einem Reed-Kontakt (5) als Schaltelement umfasst, **dadurch gekennzeichnet, dass** an der vormontierten Schalteinheit (7) ein dynamischer Übergangswiderstand sowie ein Einschwingverhalten des Reed-Kontaktes (5) gemessen werden.

2. Verfahren zur Prüfung einer Behälterwarnvorrichtung nach Anspruch 1, **dadurch gekennzeichnet, dass** an der vormontierten Schalteinheit (7) eine Empfindlichkeit einer Anzugserregung sowie einer Abfallerregung des Reed-Kontaktes (5) gemessen wird.

3. Verfahren zur Prüfung einer Behälterwarnvorrichtung nach Anspruch 1 oder 2, **dadurch gekennzeichnet, dass** an der vormontierten Schalteinheit (7) ein statischer Übergangswiderstand des Reed-Kontaktes (5) gemessen wird.

4. Verfahren zur Prüfung einer Behälterwarnvorrichtung nach einem der Ansprüche 1 bis 3, **dadurch gekennzeichnet, dass** an der vormontierten Schalteinheit (7) ein Schaltweg sowie eine Schaltzeit gemessen werden.

5. Verfahren zur Prüfung einer Behälterwarnvorrichtung einem der Ansprüche 1 bis 4, **dadurch gekennzeichnet, dass** die Prüfschritte in den Fertigungsprozess der Schalteinheit (7) integriert sind.

6. Verfahren zur Prüfung einer Behälterwarnvorrichtung nach einem der vorangegangenen Ansprüche, **dadurch gekennzeichnet, dass** wenigstens zwei Messungen des statischen Übergangswiderstandes durchgeführt werden und eine Widerstands-Differenz ermittelt wird.

7. Verfahren zur Prüfung einer Behälterwarnvorrichtung nach Anspruch 6, **dadurch gekennzeichnet, dass** zehn Messungen des statischen Übergangswiderstandes durchgeführt werden und eine max. Widerstands-Differenz ermittelt wird.

8. Verfahren zur Prüfung einer Behälterwarnvorrichtung nach einem der vorangegangenen Ansprüche, **dadurch gekennzeichnet, dass** wenigstens zwei Messungen des dynamischen Übergangswiderstandes durchgeführt werden und eine Widerstands-Differenz ermittelt wird.

9. Verfahren zur Prüfung einer Behälterwarnvorrichtung nach Anspruch 8, **dadurch gekennzeichnet, dass** hundert Messungen des dynamischen Übergangswiderstandes durchgeführt werden und eine max. Widerstands-Differenz ermittelt wird.

10. Verfahren zur Prüfung einer Behälterwarnvorrichtung nach einem der Ansprüche 1 bis 9, **dadurch gekennzeichnet, dass** die Schalteinheit (7) mit den Prüfwerten **gekennzeichnet** wird.

11. Verfahren zur Prüfung einer Behälterwarnvorrichtung nach Anspruch 10, **dadurch gekennzeichnet, dass** die einzelnen Prüfwerte als Data Matrix Code verschlüsselt auf die Schalteinheit (7) aufgetragen werden.

12. Verfahren zur Prüfung einer Behälterwarnvorrichtung nach Anspruch 11, **dadurch gekennzeichnet, dass** der Data Matrix Code auf die Schalteinheit (7) aufgelasert wird.

13. Prüfvorrichtung zur Prüfung einer Behälterwarnvorrichtung umfassend eine Schalteinheit (7) mit wenigstens einem Reed-Kontakt (5) als Schaltelement, **dadurch gekennzeichnet, dass** mittels der Prüfvorrichtung die Prüfung der Schalteinheit (7) mittels eines Verfahrens zur Prüfung nach einem der Ansprüche 1 bis 12 ausführbar ist.

14. Prüfvorrichtung nach Anspruch 13, **dadurch gekennzeichnet, dass** die Prüfvorrichtung in eine Fertigungseinheit integriert vorgesehen ist.

## Claims

1. Method for testing a reservoir warning apparatus of a fluid reservoir (1), in particular for a hydraulic motor vehicle brake system, with the reservoir warning apparatus comprising a switching unit (7) with at least one reed contact (5) as the switching element, **characterized in that** a dynamic contact resistance and a transient response of the reed contact (5) are measured at the preassembled switching unit (7).

2. Method for testing a reservoir warning apparatus according to Claim 1, **characterized in that** the sensitivity of a pull-in excitation and a dropout excitation of the reed contact (5) is measured at the preassembled switching unit (7).

3. Method for testing a reservoir warning apparatus according to Claim 1 or 2, **characterized in that** a static contact resistance of the reed contact (5) is measured at the preassembled switching unit (7).

4. Method for testing a reservoir warning apparatus according to one of Claims 1 to 3, **characterized in that** a switching path and a switching time are measured at the preassembled switching unit (7).

5. Method for testing a reservoir warning apparatus according to one of Claims 1 to 4, **characterized in that** the test steps are integrated in the production process of the switching unit (7).

6. Method for testing a reservoir warning apparatus according to one of the preceding claims, **characterized in that** at least two measurements of the static contact resistance are carried out and a difference between the resistances is determined.

7. Method for testing a reservoir warning apparatus according to Claim 6, **characterized in that** ten measurements of the static contact resistance are carried out and a maximum difference between the resistances is determined.

8. Method for testing a reservoir warning apparatus according to one of the preceding claims, **characterized in that** at least two measurements of the dynamic contact resistance are carried out and a difference between the resistances is determined.

9. Method for testing a reservoir warning apparatus according to Claim 8, **characterized in that** a hundred measurements of the dynamic contact resistance are carried out and a maximum difference between the resistances is determined.

10. Method for testing a reservoir warning apparatus according to one of Claims 1 to 9, **characterized in that** the switching unit (7) is identified with the test values.

11. Method for testing a reservoir warning apparatus according to Claim 10, **characterized in that** the individual test values are transmitted to the switching unit (7) encrypted in the form of the data matrix code.

12. Method for testing a reservoir warning apparatus according to Claim 11, **characterized in that** the data matrix code is lasered onto the switching unit (7).

13. Test apparatus for testing a reservoir warning apparatus comprising a switching unit (7) with at least one reed contact (5) as the switching element, **characterized in that** the switching unit (7) can be tested by means of a test method according to one of Claims 1 to 12 using the test apparatus.

14. Test apparatus according to Claim 13, **characterized in that** the test apparatus is integrated in a production unit.

## Revendications

1. Procédé de contrôle d'un dispositif d'alerte de réservoir d'un réservoir de compensation (1), notamment pour un équipement de freinage hydraulique de véhicule automobile, le dispositif d'alerte de réservoir comprenant une unité de commutation (7) avec au moins un contact reed (5) en tant qu'élément de commutation, **caractérisé en ce qu'**une résistance de transition dynamique ainsi qu'un comportement d'auto-oscillation du contact reed (5) sont mesurés sur l'unité de commutation (7) prémontée.

2. Procédé de contrôle d'un dispositif d'alerte de réservoir selon la revendication 1, **caractérisé en ce qu'**une sensibilité d'une excitation de collage ainsi que d'une excitation de décollage du contact reed (5) est mesurée sur l'unité de commutation (7) prémontée.

3. Procédé de contrôle d'un dispositif d'alerte de réservoir selon la revendication 1 ou 2, **caractérisé en ce qu'**une résistance de transition statique du contact reed (5) est mesurée sur l'unité de commutation (7) prémontée.

4. Procédé de contrôle d'un dispositif d'alerte de réservoir selon l'une des revendications 1 à 3, **caractérisé en ce qu'**une course de commutation ainsi qu'un temps de commutation sont mesurés sur l'unité de commutation (7) prémontée.

5. Procédé de contrôle d'un dispositif d'alerte de réservoir selon l'une des revendications 1 à 4, **caractérisé en ce que** les étapes de contrôle sont intégrées dans le processus de fabrication de l'unité de commutation (7).

6. Procédé de contrôle d'un dispositif d'alerte de réservoir selon l'une des revendications précédentes, **caractérisé en ce qu'**au moins deux mesures de la résistance de transition statique sont effectuées et une différence de résistance est déterminée.

7. Procédé de contrôle d'un dispositif d'alerte de réservoir selon la revendication 6, **caractérisé en ce que** dix mesures de la résistance de transition statique sont effectuées et une différence de résistance maximale est déterminée.

8. Procédé de contrôle d'un dispositif d'alerte de réservoir selon l'une des revendications précédentes, **caractérisé en ce qu'**au moins deux mesures de la résistance de transition dynamique sont effectuées et une différence de résistance est déterminée.

9. Procédé de contrôle d'un dispositif d'alerte de réservoir selon la revendication 8, **caractérisé en ce que** cent mesures de la résistance de transition dynamique sont effectuées et une différence de résistance maximale est déterminée.

10. Procédé de contrôle d'un dispositif d'alerte de réservoir selon l'une des revendications 1 à 9, **caractérisé en ce que** l'unité de commutation (7) est **caractérisée** avec les valeurs de contrôle.

11. Procédé de contrôle d'un dispositif d'alerte de réservoir selon la revendication 10, **caractérisé en ce que** les valeurs de contrôle individuelles sont reportées sur l'unité de commutation (7) en étant cryptées sous la forme d'un code matriciel de données.

12. Procédé de contrôle d'un dispositif d'alerte de réservoir selon la revendication 11, **caractérisé en ce que** le code matriciel de données est reporté au laser sur l'unité de commutation (7).

13. Dispositif de contrôle pour contrôler un dispositif d'alerte de réservoir comprenant une unité de commutation (7) avec au moins un contact reed (5) en tant qu'élément de commutation, **caractérisé en ce que** le contrôle de l'unité de commutation (7) peut être réalisé à l'aide du dispositif de contrôle au moyen d'un procédé de contrôle selon l'une des revendications 1 à 12.

14. Dispositif de contrôle selon la revendication 13, **caractérisé en ce que** le dispositif de contrôle est prévu de façon intégrée dans une unité de fabrication.
